# EUROPEAN PATENT APPLICATION

(11) **EP 4 614 177 A1**
(43) Date of publication of application: **10.09.2025**
(21) Application number: 24162003.8
(22) Date of filing: 07.03.2024
(51) Int. Cl.: G01R 33/56, G01R 33/48, G06T 3/4053

(54) **SUPER-RESOLUTION WITH NON-RECTANGULAR ACQUISITIONS**

(71) Applicant: Siemens Healthineers AG, 91301 Forchheim (DE)
(72) Inventor: Nickel, Marcel Dominik, 91074 Herzogenaurach (DE); Zeller, Mario, 91054 Erlangen (DE); Zhou, Kun, Shenzhen, 518052 (CN)
(74) Representative: Siemens Healthineers Patent Attorneys

(57) **Abstract**

A method for increasing the resolution of magnetic resonance image data (BD) of an examination object based on magnetic resonance raw data (KD) being acquired using a non-rectangular acquisition scheme is described. The method comprises the step of extracting a rectangular portion (EXT-KD) of the acquired magnetic resonance raw data (KD), wherein the rectangular portion (EXT-KD) comprises a completely sampled k-space portion of the non-rectangular k-space portion. Further, the method comprises the step of transforming the extracted rectangular portion (EXT-KD) into image data space, wherein image data (RD-BD) are generated based on reduced rectangular k-space. Furthermore, the method includes the step of generating high resolution image data (HD-BD) based on the image data (RD-BD) by applying a super resolution method to the image data (RD-BD). The method also comprises the step of transforming the high resolution image data (HD-BD) into k-space, wherein high resolution raw data (HD-KD) are generated. The method comprises the step of partly replacing the high resolution raw data (HD-KD) by original raw data assigned to the non-rectangular portion of the acquired magnetic resonance raw data (KD), wherein consistent high resolution raw data (K-HD-KD) are generated. Eventually, the consistent high resolution raw data (K-HD-KD) are transformed into image data space, wherein consistent high resolution image data (K-HD-BD) are generated. Further, an interpolation device (60) is described. Furthermore, a magnetic resonance imaging system (70) is described.

## Description

The invention relates to a method for increasing the resolution of magnetic resonance image data of an examination object based on magnetic resonance raw data being acquired using a non-rectangular acquisition scheme. The invention also relates to an interpolation device. Further, the invention relates to a magnetic resonance imaging system.

Imaging systems that are based on a method of magnetic resonance measurement, in particular of nuclear spins, so-called magnetic resonance tomographs, have been successfully established and proven through a wide range of applications. In this type of image acquisition, a static basic magnetic field B0, which is used for the initial alignment and homogenization of magnetic dipoles to be examined, is usually superimposed with a quickly switched magnetic field, the so-called gradient field, for spatial resolution of the imaging signal. To determine the material properties of an examination object to be imaged, the dephasing or relaxation time is determined after the magnetization is deflected from the initial orientation, so that various material-typical relaxation mechanisms or relaxation times can be identified. The deflection is usually carried out by a number of HF pulses (the abbreviation HF stands for high frequency), also referred to as excitation pulses, and the spatial resolution is based on a time-determined manipulation of the deflected magnetization with the help of the gradient field in a so-called measurement sequence or control sequence, which determines an exact temporal sequence of HF pulses, the change in the gradient field (by sending out a switching sequence of gradient pulses) and the acquisition of measured values.

Typically, an association between measured magnetization - from which the material properties mentioned can be derived - and a spatial coordinate of the measured magnetization in the spatial space in which the object under examination is arranged is carried out using an intermediate step. In this intermediate step, acquired magnetic resonance raw data, also referred to as k-space data, are arranged at readout points in the so-called "k-space", whereby the coordinates of the k-space are encoded as a function of the gradient field. The amount of magnetization (in particular the transverse magnetization in a plane transverse to the basic magnetic field described above) at a specific location on the examination object can be determined from the data of the readout point using a Fourier transformation, which consists of a signal strength (amount of magnetization), which is assigned to a specific frequency (the spatial frequency) or phase position, calculates a signal strength of the signal in the spatial space.

However, often only a partial scan of the k-space is carried out in order to save time. However, the reduced sampling of the k-space leads to a reduction in the image information reconstructed on the basis of the sampled k-space data, in particular to a reduction in the image resolution. To compensate for this loss of information, there are methods that compensate for undersampling. Such methods can be associated with an augmentation of the k-space data or can be aimed at directly increasing the resolution in the image data space.

Super-resolution is a means of improving the image quality in magnetic resonance imaging in the sense of improving the image resolution in the image data space. Super-resolution can be achieved through machine learning, with the goal being to increase the resolution of an image, often by four times or more.

Deep Resolve Sharp (DRS) is a method for interpolating MR images using a neural super-resolution network (see e.g. Zhang et al., "Residual Dense Network for Image Super-Resolution", C VPR paper in Open Access version provided by the Computer Vision Foundation). Compared to conventional interpolation methods such as bicubic interpolation or k-space-based zero filling, images interpolated with DRS generally have higher image sharpness because the network has been trained on a variety of edge types.

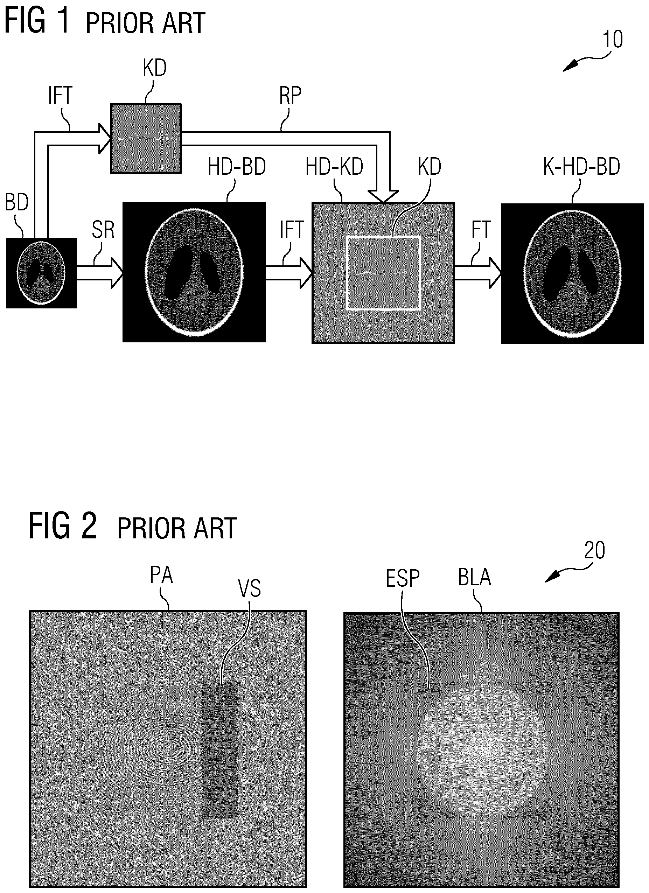

In a product setting, the method works as such that a rectangular complex-valued image is fed into the interpolation network which interpolates each image dimension by a factor of 2. For data consistency reasons, the upsampled image is then transformed into k-space and the center is replaced by the original image's k-space. The final image is then obtained by transforming back into image space as it is illustrated in FIG 1.

However, the method can currently not be applied to non-rectangular input data or data with Partial Fourier or asymmetric sampling acquisitions as the data consistency step results in zero-valued areas or sharp edges, which result in ringing artifacts after Fourier transform in image space and lead therefore to a deteriorated image quality. Such zero-valued areas are shown in FIG 2.

The data to be used for consistency are not able to be specified as a subset of the input data because we have to treat the network used for super-resolution as a "black box".

It is therefore a task in magnetic resonance imaging to improve the image quality when scanning k-space with a non-rectangular acquisition scheme.

This task is accomplished by a method for increasing the resolution of magnetic resonance image data of an examination object based on magnetic resonance raw data being acquired using a non-rectangular acquisition scheme according to claim 1, by an interpolation device according to claim 12 and by a magnetic resonance imaging system according to claim 13.

According to the method for increasing the resolution of magnetic resonance image data of an examination object based on magnetic resonance raw data being acquired using a non-rectangular acquisition scheme a rectangular portion of the acquired magnetic resonance raw data is extracted, wherein the rectangular portion comprises a completely scanned k-space portion. "A completely scanned k-space portion" means that there are no sub-portions in the scanned k-space portion not being sampled due to the geometry of the non-rectangular acquisition scheme. In particular, there are no edge sub-portions being not sampled due to the determined dimensions for the rectangular portion. "Raw data" are measurement data arranged in k-space. In contrast thereto, image data are represented in image data space and can be determined by transforming raw data from k-space into image data space using a Fourier transform, in particular a Fast Fourier transform.

Then, the raw data assigned to the extracted rectangular portion are transformed into image data space, wherein image data based on reduced rectangular k-space are generated. The transformation into image data space is realized, because the super-resolution method is basically performed in image data space.

Further, high resolution image data are generated based on the image data by applying a super-resolution method to the image data which are based on k-space data assigned to the extracted rectangular portion. Super-resolution, in particular using a Residual Dense Network, is described in Zhang et al. being already cited above.

After increase of resolution, the high resolution image data are transformed back into k-space using inverse Fourier transform, wherein high resolution raw data are generated.

After transformation back into k-space, high resolution raw data are partly replaced by the original raw data comprising raw data assigned to the non-rectangular portion of the acquired magnetic resonance raw data. In this manner, consistent high resolution raw data are generated.

After generation of consistency, the consistent high resolution raw data are transformed into image data space using a Fourier transformation, wherein consistent high resolution image data are generated.

Advantageously, by extracting a rectangular portion of the k-space data, which is a real subset of the non-rectangular portion, the input of "empty" k-space into a super-resolution network is avoided and by inserting k-space data assigned to the non-rectangular portion which does not include empty k-space portions, ringing artifacts etc. are reduced dramatically compared to prior art.

The interpolation device according to the invention comprises an extraction unit for extracting a rectangular portion of acquired magnetic resonance raw data, wherein the rectangular portion comprises a completely scanned k-space portion. That means that the rectangular portion does not include any "empty portion" of k-space. As mentioned above, the exclusion of any empty portion enables to avoid artifacts in the step of increasing the resolution, because the super-resolution algorithm is adapted to rectangular k-space sampling methods and rectangular k-space portions without any empty portion.

The interpolation device also comprises a transformation unit for transforming the extracted rectangular portion into image data space, wherein image data based on reduced rectangular k-space are generated.

The interpolation device also comprises a super-resolution unit for generating high resolution image data based on the image data by applying a super-resolution method to the generated image data.

Part of the interpolation device is also a high resolution transformation unit for transforming the high resolution image data into k-space, wherein high resolution raw data are generated.

Further, the interpolation device includes a replacing unit for partly replacing the high resolution raw data by the original raw data assigned to the non-rectangular k-space portion of the acquired magnetic resonance raw data, wherein consistent high resolution raw data are generated.

Furthermore, the interpolation device comprises a consistent data transformation unit for transforming the consistent high resolution raw data into image data space, wherein consistent high resolution image data are generated.

The interpolation device according to the invention shares the advantages of the method for increasing the resolution of magnetic resonance image data of an examination object based on magnetic resonance raw data being acquired using a non-rectangular acquisition scheme according to the invention.

The magnetic resonance imaging system according to the invention includes a scan unit for acquiring magnetic resonance raw data from an examination object. The magnetic resonance imaging system also includes a control unit for controlling the acquisition and for reconstructing image data based on the acquired magnetic resonance raw data. Further, the magnetic resonance imaging system comprises an interpolation device according to the invention, which is arranged for generating high resolution image data.

The magnetic resonance imaging system according to the invention shares the advantages of the interpolation device according to the invention, which is arranged for generating high resolution image data.

Some units or modules of the interpolation device mentioned above can be completely or partially realized as software modules running on a processor of a respective computing system, e.g. of a control device of a magnetic resonance imaging system. A realization largely in the form of software modules can have the advantage that applications already installed on an existing computing system can be updated, with relatively little effort, to install and run these units of the present application. The object of the invention is also achieved by a computer program product with a computer program that is directly loadable into the memory of a computing system, and which comprises program units to perform the steps of the inventive method for increasing the resolution of magnetic resonance image data of an examination object based on magnetic resonance raw data being acquired using a non-rectangular acquisition scheme, when the program is executed by the computing system. In addition to the computer program, such a computer program product can also comprise further parts such as documentation and/or additional components, also hardware components such as a hardware key (dongle etc.) to facilitate access to the software.

A computer readable medium such as a memory stick, a hard-disk or other transportable or permanently-installed carrier can serve to transport and/or to store the executable parts of the computer program product so that these can be read from a processor unit of a computing system. A processor unit can comprise one or more microprocessors or their equivalents.

The dependent claims and the following description each contain particularly advantageous embodiments and developments of the invention. In particular, the claims of one claim category can also be developed analogously to the dependent claims of another claim category. In addition, within the scope of the invention, the various features of different exemplary embodiments and claims can also be combined to form new exemplary embodiments.

In a variant of the method according to the invention, the extracted rectangular portion of the acquired magnetic resonance raw data comprises a real subset of the non-rectangular k-space portion. Since the real subset is an area in k-space, which is completely sampled, the extracted rectangular portion can be input to the super-resolution network without any empty edge portions and therefore, ringing artifacts resulting from the super-resolution step can be avoided.

Preferably, the non-rectangular acquisition scheme of the method according to the invention comprises a 2D non-rectangular acquisition scheme. A 2D acquisition scheme is much more efficient than a 3D acquisition scheme due to a huge reduction of amount of raw data and need for reconstruction time.

Particularly preferred, the non-rectangular acquisition scheme comprises one of the following types of acquisition schemes:
- a radial acquisition scheme,
- a PROPELLER acquisition scheme,
- a 2D BLADE acquisition scheme,
- a spiral imaging acquisition scheme,
- an elliptical acquisitions scheme.

In radial scanning, k-space is scanned by a radial k-space trajectory, which consists of multiple radial profiles, each passing through the center of k-space. Radial trajectories are less susceptible to motion artifacts and are therefore often used to record dynamic physiological processes. In addition, compared to Cartesian trajectories, radial trajectories are more robust against a rotationally incomplete scan, which is used in time-resolved imaging to improve temporal resolution.

The PROPELLER technique (PROPELLER is an acronym for "Periodically Rotated Overlapping Parallel Lines with Enhanced Reconstruction") was developed in the late 1990s as a method for reducing motion. The basic idea was to rotate k-space using a series of radially directed strips or "rotor blades".

Each "rotor blade" consists of several parallel phase-encoded lines that can be detected using fast spin-echo or gradient-echo methods. In common practice, 8 to 32 rotor blade lines are recorded in a single recording. The rotor blades are then rotated through a small angle (10° to 20°), during which a second data set is recorded. The process continues until image data from the entire k-space circle has been collected.

The PROPELLER trajectory through k-space offers some unique advantages. The center of k-space (which contains the highest signal amplitude and contributes the most to image contrast) is oversampled, meaning that the signal-to-noise ratio and contrast-to-noise ratio are high. Oversampling in this area also provides redundancy of information, meaning that the data for each new blade can be compared to data from previous blades for consistency. As the patient moves between acquiring k-space data from different blades, the data for the next blade can be corrected (or even discarded entirely) depending on how anomalous its central information appears.

In a variant of the method for increasing the resolution of magnetic resonance image data of an examination object based on magnetic resonance raw data assigned to a non-rectangular k-space portion, being acquired using a non-rectangular acquisition scheme according to the invention, the consistent high resolution raw data are used for another increasing of resolution based on super-resolution. That means that the method for increasing the resolution is repeated once again, wherein the result of the first loop pass is used as input data for the second loop pass. Advantageously, in the second loop pass, there is no empty space in the input data and therefore, the extracted rectangular portion of the acquired magnetic resonance raw data can be expanded above the non-rectangular acquisition scheme. That means that in the second loop pass, the area of the rectangular portion can be increased and also the resolution of image data based on reduced rectangular k-space, which is the input for the super-resolution algorithm can be increased. Hence, the resolution of the result of the super-resolution algorithm is increased with every loop pass without generating the above-mentioned artifacts caused by empty k-space portions.

In a preferred variant of the method according to the invention, the non-rectangular acquisition scheme comprises a 3D non-rectangular acquisition scheme. 3D acquisition schemes are suitable for acquiring data not in layers but in volumes. This makes it easier, for example, to create arbitrary layer orientations when viewing.

Preferably, such a 3D-non-rectangular acquisition scheme comprises a stack-of-stars acquisition scheme. Such a stack-of-stars scheme is appropriate also for 3D imaging, with scanning taking place radially. It is also just an example of a non-Cartesian 3D recording technique.

Preferably, the method according to the invention is iteratively repeated for further increasing the resolution of the image data, until a predetermined resolution value is achieved. Advantageously, any desired resolution can be achieved for the reconstructed image data.

Preferably, for each iteration lap the rectangular portion is increased compliant with the consistent high resolution raw data of the last iteration lap. Advantageously, the resolution is increased in each lap without generating ringing artifacts. It is conceivable to apply a larger cropped volume such that the edges of the sequences that are inserted into the super-resolution are not acquired. You may accept a certain amount of data not being included at the edge, so for example the rectangle expands a little up and down a little, even if 5% of the data is missing at the corners, for example.

In a very preferred variant of the method according to the invention, the acquired magnetic resonance raw data cover a circle in the 2D k-space and the extracted rectangular portion comprises a square which is a real subset of the circle, since the format of the input data of the super-resolution algorithm is predetermined as a rectangle. Advantageously, if the acquisition schema is dimensioned as a circle, a square is optimal format compared to other rectangle formats.

Preferably, the square comprises the maximum possible area in the circle such that as much information as possible is input into the super-resolution network.

The invention is explained below with reference to the figures enclosed once again. The same components are provided with identical reference numbers in the various figures.

The figures are usually not to scale.
- FIG 1: shows a schematic diagram, illustrating a method for increasing the resolution of magnetic resonance image data according to prior art,
- FIG 2: shows examples of k-spaces after a data consistency step for an acquisition with asymmetric sampling in readout direction and a BLADE acquisition,
- FIG 3: shows a schematic diagram, illustrating a method for increasing the resolution of magnetic resonance image data according to an embodiment of the invention,
- FIG 4: shows a schematic diagram, illustrating a method for increasing the resolution of magnetic resonance image data according to an alternative embodiment of the invention,
- FIG 5: shows a flow chart, illustrating a method for increasing the resolution of magnetic resonance image data according to an embodiment of the invention,
- FIG 6: shows a schematic view on an interpolation device according to an embodiment of the invention,
- FIG 7: shows a schematic view on a magnetic resonance imaging system according to an embodiment of the invention.

In FIG 1, a schematic diagram 10, illustrating a method for increasing the resolution of magnetic resonance image data according to prior art is visualized. The method works as such that a rectangular complex-valued image BD is fed into an interpolation network SR which interpolates each image dimension by a factor 2 such that high resolution image data HD-BD are generated. For data consistence reasons, the upsampled image data HD-BD are then transformed into k-space data HD-KD using an inverse Fourier transform IFT and the k-space center is replaced in a replacement step RP by the original k-space data KD. The final consistent high resolution image data K-HD-BD are then obtained by transforming the consistent high resolution raw data K-HD-KD into image space using a Fourier transform FT.

However, the conventional method can currently not be applied to non-rectangular sampled raw data or data with Partial Fourier acquisition schemes or asymmetric sampling acquisition schemes since the data consistency step results in zero-valued areas or sharp edges, which result in ringing artifacts after Fourier transformation in image space.

In FIG 2, a diagram 20 is illustrated including examples of k-spaces after a data consistency step for an acquisition with asymmetric sampling in readout direction and a BLADE acquisition. On the left side, a k-space diagram PA representing an acquisition with asymmetric sampling in readout direction is illustrated. On the right side, a k-space diagram BLA of a BLADE acquisition after consistency step is illustrated.

As can be seen in FIG 2, a vertical strip VS in the replacing portion in the k-space including no raw data exists which cause ringing artefacts in high resolution image data. In the right image, the replacing portion in k-space comprises on the edge area empty sub-portions ESP, which also do not include any raw data.

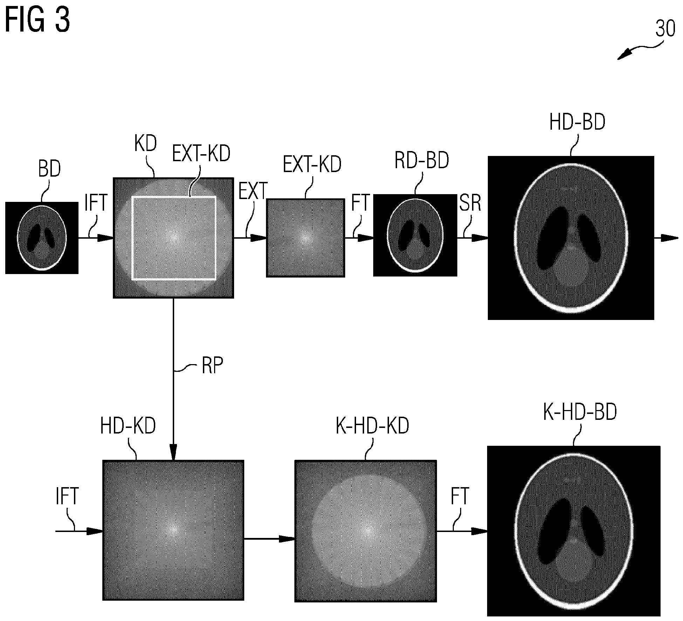

In FIG 3, a schematic diagram 30 is shown, illustrating a method for increasing the resolution of magnetic resonance image data according to an embodiment of the invention. The example shown in FIG 3 refers to a BLADE acquisition scheme. Since the original k-space data have been acquired as rotated blades, k-space is only available as a quasi-circular shape. To avoid results as illustrated in FIG 2, the k-space of the input image BD is restricted to the quadratic white area which amounts 2/n = 64 % of the original k-space data KD such that extracted k-space data EXT-KD are generated. Then, image data RD-BD, which are based on the extracted k-space data EXT-KD, are generated. These image data RD-BD are further fed into a super-resolution network SR. The super-resolution network SR generates high resolution image data HD-BD. After that, the high resolution image data HD-BD are transformed into k-space such that high resolution k-space data HD-KD are generated. For consistency, the original circular area of the initial raw data KD is inserted into the k-space of the high resolution k-space data HD-KD such that consistent high resolution k-space data K-HD-KD are generated. Based on the consistent high resolution k-space data K-HD-KD, consistent high resolution image data K-HD-BD are finally generated by transforming the consistent high resolution k-space data K-HD-KD into image space.

Due to the reduced matrix size of the restricted and extracted k-space data EXT-KD used for super resolution, the upsampling factor compared to the original matrix size is smaller than for an original rectangular dataset. Because the black areas of original k-space data KD are filled as well, the ratio of k-space points of interpolated data versus original data is still 8/n = 2.55 compared to 4 in a conventional rectangular use case.

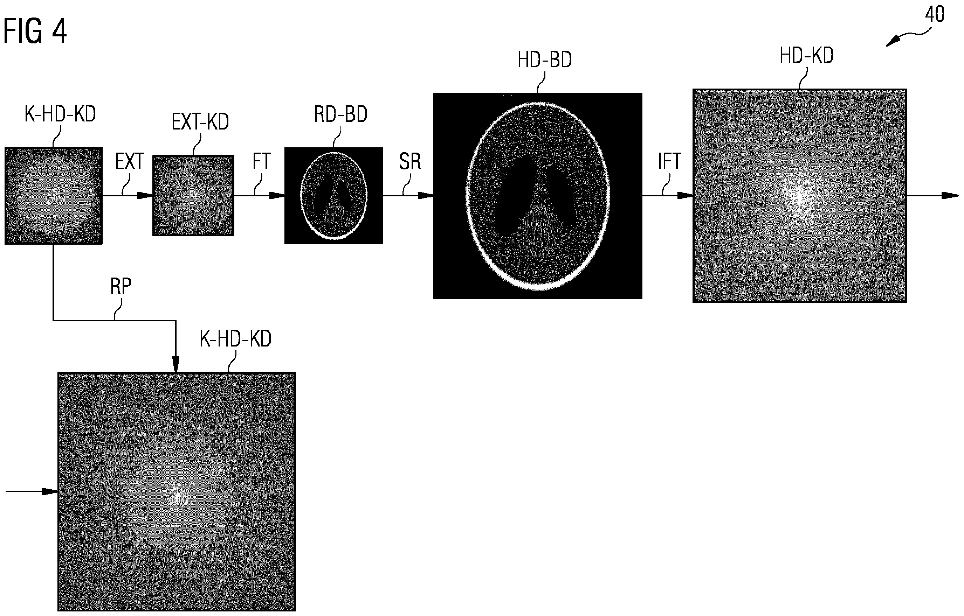

In FIG 4, a schematic diagram 40 is shown, illustrating a method for increasing the resolution of magnetic resonance image data according to an alternative embodiment of the invention. In the method illustrated in FIG 4, the consistent high resolution k-space data K-HD-KD generated by the method illustrated in FIG 3 is used as input data. Then, another super resolution step is carried out. Extracted k-space data EXT-KD are generated such that the size is just the size of the original k-space data KD used as input data in the method shown in FIG 3. In contrast to the original k-space data KD used as input data in the method of FIG 3, the areas outside of the circular portion are now (in FIG 4) filled with data and can be used as rectangular input for the super-resolution network SR. After generating high resolution k-space data HD-KD, a consistency step is carried out again, wherein the original k-space data KD are inserted in the center of the high resolution k-space data HD-KD such that consistent high resolution k-space data K-HD-KD are generated. The last step of transforming consistent high resolution k-space data K-HD-KD into image data is left out in FIG 4 for the sake of simplicity.

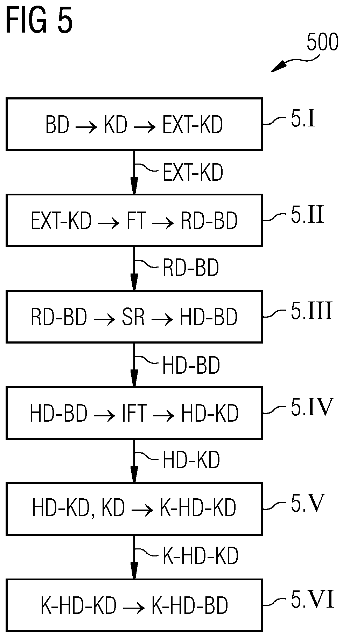

In FIG 5, a flow chart 500 is shown, illustrating a method for increasing the resolution of magnetic resonance image data according to an embodiment of the invention.

In step 5.I, a rectangular portion EXT-KD of the acquired magnetic resonance raw data KD is extracted. The rectangular portion EXT-KD comprises a completely scanned k-space portion.

In step 5.II, the extracted rectangular portion EXT-KD is transformed into image data space using a Fourier transform FT and image data RD-BD, based on reduced rectangular k-space, are generated.

In step 5.III, high resolution image data HD-BD are generated based on the image data RD-BD by applying a super resolution method to the image data RD-BD.

In step 5.IV, the high resolution image data HD-BD are transformed into k-space using an inverse Fourier transform IFT and high resolution raw data HD-KD are generated.

In step 5.V, the high resolution raw data HD-KD are partly replaced by the rectangular portion of the acquired magnetic resonance raw data KD and consistent high resolution raw data K-HD-KD are generated.

In step 5.VI, the consistent high resolution raw data K-HD-KD are transformed into image data space, wherein consistent high resolution image data K-HD-BD are generated.

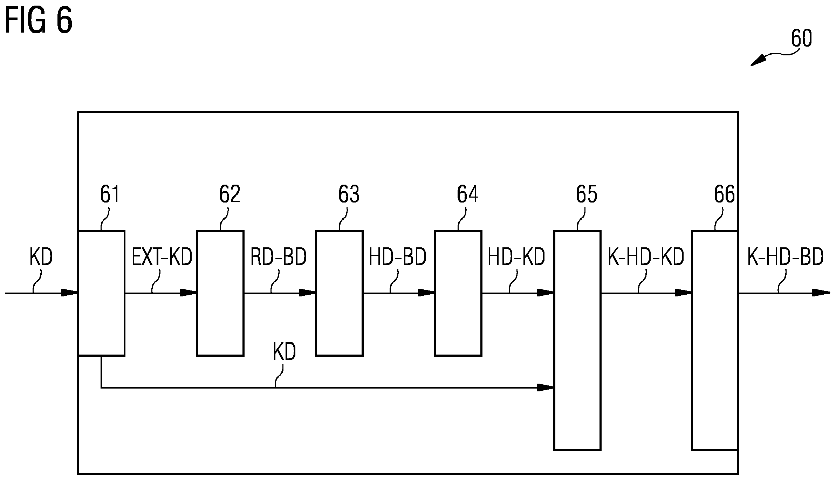

In FIG 6, a schematic view on an interpolation device 60 according to an embodiment of the invention is shown.

The interpolation device 60 comprises an extraction unit 61 for extracting a rectangular portion EXT-KD of acquired magnetic resonance raw data KD including a non-rectangular k-space portion, wherein the rectangular portion EXT-KD comprises a real subset of the non-rectangular k-space portion.

Part of the interpolation device 60 is also a transformation unit 62 for transforming the extracted rectangular portion EXT-KD into image data space, wherein image data RD-BD based on a reduced rectangular k-space are generated.

The interpolation device 60 comprises a super resolution unit 63 for generating high resolution image data HD-BD based on the image data RD-BD, which are generated based on a reduced rectangular k-space, by applying a super resolution method to the image data RD-BD.

Further, the interpolation device 60 comprises a high resolution transformation unit 64 for transforming the high resolution image data HD-BD into k-space, wherein high resolution raw data HD-KD are generated.

Furthermore, the interpolation unit 60 includes a replacing unit 65 for partly replacing the high resolution raw data HD-KD by the non-rectangular k-space portion of the acquired magnetic resonance raw data KD, wherein consistent high resolution raw data K-HD-KD are generated.

The interpolation device also comprises a consistent data transformation unit 66 for transforming the consistent high resolution raw data K-HD-KD into image data space, wherein consistent high resolution image data K-HD-BD are generated.

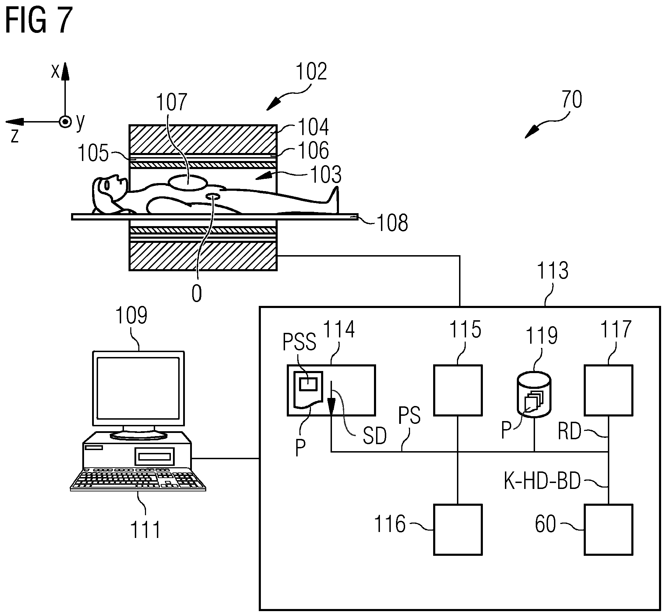

In FIG 7, a schematic view on a magnetic resonance imaging system according to an embodiment of the invention is shown.

FIG 7 shows a roughly schematic representation of a magnetic resonance system 70 according to the invention (hereinafter referred to as "MR system" for short). On the one hand, it includes the actual magnetic resonance scanner 102 with an examination room 103 or patient tunnel, in which, on a couch 108, a patient O, in whose body there is, for example, a specific object to be imaged like an organ is located, can be retracted.

The magnetic resonance scanner 102 is equipped in the usual way with a basic field magnet system 104, a gradient system 106 as well as an HF transmitting antenna system 105 and an HF receiving antenna system 107. In the exemplary embodiment shown, the HF transmitting antenna system 105 is a whole-body coil permanently installed in the magnetic resonance scanner 102, whereas the HF receiving antenna system 107 consists of local coils to be arranged on the patient or test subject (in FIG 7 only by a single local coil symbolized). In principle, however, the whole body coil 105 can also be used as an HF receiving antenna system and the local coils 107 as an HF transmitting antenna system, provided that these coils can each be switched to different operating modes.

The MR system 70 also has a central control device 113, which is used to control the MR system 70. This central control device 113 includes a sequence control unit 114 for pulse sequence control. This is used to control the temporal sequence of high-frequency pulses (HF pulses) and gradient pulses depending on a selected imaging sequence PS according to a pulse sequence scheme PSS. Such an imaging sequence PS or the pulse sequence scheme PSS on which the imaging sequence PS is based can be specified, for example, within a measurement or control protocol P. Usually, different control protocols P for different measurements are stored in a memory 119 and can be selected by an operator (and changed if necessary) and then used to carry out the measurement.

To output the individual HF pulses, the central control device 113 has a high-frequency transmitting device 115, which generates the HF pulses, amplifies them and feeds them into the HF transmitting antenna system 105 via a suitable interface (not shown in detail). To control the gradient coils of the gradient system 106, the control device 113 has a gradient system interface 116. The sequence control unit 114 communicates in a suitable manner, e.g. by sending out sequence control data SD, with the high-frequency transmitting device 115 and the gradient system interface 116 for sending out the pulse sequences PS. The control device 113 also has a high-frequency receiving device 117 (which also communicates in a suitable manner with the sequence control unit 114) in order to be coordinated by the HF transmitting antenna system 107 to acquire received magnetic resonance signals.

The central control device 113 also includes an interpolation device 60 according to the invention, which has the structure illustrated in detail in FIG 6.

The interpolation device 60 also takes over the acquired data RD after demodulation and digitization as raw data or k-space data RD and reconstructs consistent high resolution magnetic resonance image data K-HD-BD from it. These magnetic resonance image data, optimized in terms of its resolution are then stored in a memory 119, for example.

The central control device 113 can be operated via a terminal with an input unit 111 and a display unit 109, via which the entire MR system 70 can also be operated by an operator. MR images can also be displayed on the display unit 109, and measurements can be planned and started using the input unit 111, if necessary in combination with the display unit 109, and in particular suitable control protocols with suitable ones measuring sequences can be selected as explained above and modified if necessary.

The MR system 70 according to the invention and in particular the control device 113 can also have a large number of other components that are not shown in detail here but are usually present on such devices, such as a network interface to connect the entire system to a network and to be able to exchange raw data RD and/or image data K-HD-BD or parameter cards, but also other data, such as patient-relevant data or control protocols.

Finally, it should be pointed out once again that the detailed methods and structures described above are exemplary embodiments and that the basic principle can also be varied in wide areas by the person skilled in the art without leaving the scope of the invention, insofar as it is specified by the claims. For the sake of completeness, it should also be noted that the use of the indefinite articles "a" or "an" does not exclude the fact that the characteristics in question can be present multiple times. Likewise, the term "unit" does not exclude the fact that it consists of several components, which may also be spatially distributed. Further, independent of the grammatical term usage, individuals with male, female or other gender identities are included within the term.

## Claims

1. Method for increasing the resolution of magnetic resonance image data (BD) of an examination object (O) based on magnetic resonance raw data (KD) assigned to a non-rectangular k-space portion, being acquired using a non-rectangular acquisition scheme, comprising the steps:
i) extracting a rectangular portion (EXT-KD) of the acquired magnetic resonance raw data (KD), wherein the rectangular portion (EXT-KD) comprises a completely sampled k-space portion of the non-rectangular k-space portion,
ii) transforming the extracted rectangular portion (EXT-KD) into image data space, wherein image data (RD-BD) are generated based on a reduced rectangular k-space,
iii) generating high resolution image data (HD-BD) based on the image data (RD-BD) by applying a super resolution method to the image data (RD-BD),
iv) transforming the high resolution image data (HD-BD) into k-space, wherein high resolution raw data (HD-KD) are generated,
v) partly replacing the high resolution raw data (HD-KD) by original raw data assigned to the non-rectangular portion k-space portion of the acquired magnetic resonance raw data (KD), wherein consistent high resolution raw data (K-HD-KD) are generated,
vi) transforming the consistent high resolution raw data (K-HD-KD) into image data space, wherein consistent high resolution image data (K-HD-BD) are generated.

2. Method according to claim 1, wherein the rectangular portion (EXT-KD) comprises a real subset of the non-rectangular k-space portion.

3. Method according to claim 1 or 2, wherein the non-rectangular acquisition scheme comprises a 2D non-rectangular acquisition scheme.

4. Method according to claim 3, wherein the 2D non-rectangular acquisition scheme comprises one of the following types of acquisition schemes:
- a 2D BLADE acquisition scheme,
- a radial acquisition scheme,
- a spiral imaging acquisition scheme.

5. Method according to claim 1 or 2, wherein the non-rectangular acquisition scheme comprises a 3D non-rectangular acquisition scheme.

6. Method according to claim 5, wherein the non-rectangular acquisition scheme comprises a stack-of-stars acquisition scheme.

7. Method according to any of the preceding claims, wherein the steps i) to v) are repeated, wherein the consistent high resolution raw data (K-HD-KD) are used in step i) instead of acquired magnetic resonance raw data (KD).

8. Method according to claim 7, wherein the steps i) to v) are iteratively repeated until a predetermined resolution value is achieved.

9. Method according to claim 8, wherein for each iteration lap the rectangular portion (EXT-KD) is increased compliant with the consistent high resolution raw data (K-HD-KD) of the last iteration lap.

10. Method according to any of the preceding claims, wherein the acquired magnetic resonance raw data (KD) cover a circle in the 2D k-space and the extracted rectangular portion (EXT-KD) comprises a square which is a real subset of the circle.

11. Method according to claim 10, wherein the square comprises the maximum possible area in the circle.

12. Interpolation device (60), comprising:
- an extraction unit (61) for extracting a rectangular portion (EXT-KD) of acquired magnetic resonance raw data (KD) assigned to a non-rectangular k-space portion, wherein the rectangular portion (EXT-KD) comprises a completely sampled k-space portion of the non-rectangular k-space portion,
- a transformation unit (62) for transforming the extracted rectangular portion (EXT-KD) into image data space, wherein image data (RD-BD) based on a reduced rectangular k-space are generated,
- a super-resolution unit (63) for generating high resolution image data (HD-BD) based on the image data (RD-BD) by applying a super-resolution method to the image data (RD-BD),
- a high resolution transformation unit (64) for transforming the high resolution image data (HD-BD) into k-space, wherein high resolution raw data (HD-KD) are generated,
- a replacing unit (65) for partly replacing the high resolution raw data (HD-KD) by original raw data assigned to the non-rectangular portion of the acquired magnetic resonance raw data (KD), wherein consistent high resolution raw data (K-HD-KD) are generated,
- a consistent data transformation unit (66) for transforming the consistent high resolution raw data (K-HD-KD) into image data space, wherein consistent high resolution image data (K-HD-BD) are generated.

13. Magnetic resonance imaging system (70), comprising:
- a scan unit (102) for acquiring magnetic resonance raw data (KD) from an examination object,
- a control unit (113) for controlling the acquisition and for reconstructing image data based on the acquired magnetic resonance raw data (KD),
- the interpolation device (60) according to claim 12 for generating high resolution image data (K-HD-BD).

14. A computer program product comprising instructions which, when the program is executed by a computer, cause the computer to carry out the steps of the method of any of claims 1 to 11.

15. A computer-readable storage medium comprising instructions which, when executed by a computer, cause the computer to carry out the steps of the method of any of claims 1 to 11.
